# EUROPEAN PATENT SPECIFICATION

(11) **EP 1 455 443 B1**
(45) Date of publication and mention of the grant of the patent: **14.11.2007**
(21) Application number: 03290496.3
(22) Date of filing: 03.03.2003
(51) Int. Cl.: H03F 1/30, H03F 1/02

(54) **Method for controlling the operating point of a transistor of a power amplifier**
Verfahren zur Arbeitspunkteinstellung eines Transistors in einem Leistungsverstärker
Méthode permettant de régler le point de fonctionnement d'un transistor d'un amplificateur de puissance

(43) Date of publication of application: 08.09.2004
(73) Proprietor: Alcatel Lucent, 75008 Paris (FR)
(72) Inventor: Nüchter, Rolf, 70734 Fellbach (DE)
(74) Representative: Schmidt, Werner Karl

(56) References cited:
- EP-A- 1 026 822
- EP-A- 1 134 890
- US-A- 5 426 641
- US-B1- 6 351 189

## Description

The invention relates to a method for controlling the operating point of a transistor of a power amplifier for amplifying time division multiplex (access) TDM(A)-signals.

The invention further relates to a computer program for carrying out said method, a power amplifier comprising a transistor the operating point of which is controlled, a transmitter comprising such a power amplifier, a transmitting station comprising at least one of said transmitters and a telecommunications system comprising at least one of said power amplifiers.

In the prior art methods for controlling the operating point of a transistor of a power amplifier are known, e. g. from US-patent 5,426,641. Said US-patent discloses an amplifier for TDMA wireless communications systems. The operating point of such amplifiers typically drifts with respect to temperature variations. In order to maintain the amplifier at a proper bias level over changing temperature conditions and free from effects of device aging and device to device variations that US patent teaches to monitor the drain current of the amplifier each frame outside a burst interval in which a portable is transmitting, i.e. when no signal is present at the amplifiers input. The drain current is controlled by adjusting the gate voltage to compensate for any variations. In particular said adjustment comprises the steps of measuring the drain current representing an actual operating point of the amplifier, in particular a transistor, with a desired value, representing a set operating point and adjusting the gate voltage with respect to the result of said comparison. According to the disclosure of this US patent all of these steps, in particular the measuring, comparing and adjusting steps are carried out all together within one null power time slot.

Starting from that prior art it is the object of the present invention to improve a known method for controlling the operating point of a transistor of a power amplifier, a computer program for carrying out said method, a power amplifier comprising such a transistor, a transmitter comprising such a power amplifier, a transmitter station comprising at least one of said transmitters and a telecommunications system comprising at least one of said power amplifiers such that the controlling of the operating point can be carried out in a cheaper manner.

This object is solved by the method claimed by new claim 1. That method is characterized in that the step of detecting a deviation between a set operating point and an actual operating point of said transistor, the step of detecting the occurrence of null power time slots or using the knowledge when they occur and the step of adjusting the bias of the gate/base of said transistor according to said deviation in order to re-establish said set operating point are carried out during separate/individual null power time slots of a TDM(A) signal.

A null power time slot in the meaning of the invention is a time slot with very low, in particular with null signal power.

Advantageously, the execution of the steps in separate time slots enables the execution of the method by using slower and thus cheaper hardware equipment.

Another advantage of the proposed solution lies in the fact that the controlling of the operating point of the transistor, i. e. the detection of a deviation between the set operating point and the actual operating point and the adjustment of the bias is not disturbed by HF-signals amplified by the power amplifier. Consequently, a more precise re-establishment of the set operating point is possible. Furthermore, the adjustment itself does not impact the HF-signal if the adjustment is done in the time where no HF-signal is applied to the transistor.

According to a preferred embodiment of said method the single steps necessary for controlling the operating point are carried out during different null power time slots comprised within said TDM(A)-signal. It is not strictly necessary that these time slots occur consecutively; the controlling of the operating point according to the claimed method is also possible during several time slots which do not occur consecutively. However, the single time slots used for carrying out the controlling of the operating point preferably occur within a time interval being much shorter than the time constant of the temperature variations causing the drift of the operating point.

According to another preferred embodiment of the present invention the adjustment of the bias is carried out iteratively during several control loops.

Further, in order to ensure a precise controlling of the operating point the controlling is done only after the transistor has reached a steady state with respect to its temperature after the power amplifier has been switched on. To make sure that the steady state has been reached the controlling operation is for example started after N null power time slots with N e. g. greater than 3, have occurred within said TDM(A)-signal.

Further advantageous embodiments of the method are subject-matters of the dependent claims.

The above-identified object is further solved by a computer program for a controlling unit of a power amplifier comprising a code being adapted to carry out the method according to the invention when running on a microprocessor. Further, the above-identified object is solved by a power amplifier for amplifying TDM(A)-signals, by a transmitter comprising such a power amplifier, by a transmitting station comprising such a transmitter and by a telecommunications system comprising such amplifiers. The advantages of said solutions correspond to the advantages outlined above with respect to the claimed method.

In the following different embodiment of the invention are described in detail by referring to the accompanying figures, wherein
- Figure 1: shows a power amplifier;
- Figure 2: shows a TDM(A)-signal; and
- Figure 3: shows a transmitter, a transmitting station and a telecommunications system.

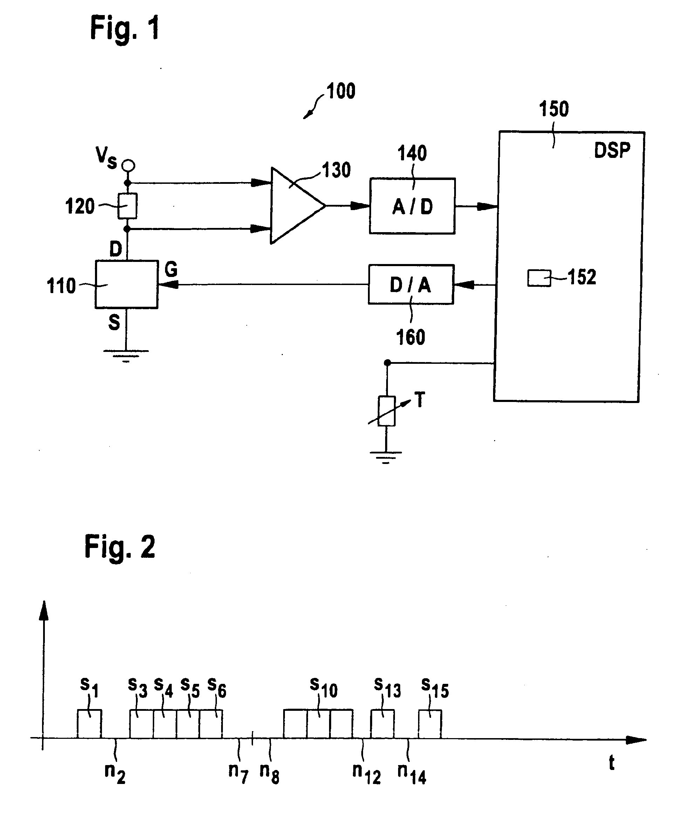

Figure 1 shows a power amplifier 100 for amplifying time division multiplex (access) TDM(A)-signals in a TDM(A) system, in particular in a Global System for Mobile communications GSM.

Figure 2 shows an example for such a TDM(A)-signal comprising data time slots sᵢ with i = 1, 3 - 6, 9 - 11, 13 and 15 and null power time slots nⱼ with j = 2, 7, 8, 12 and 14.

The power amplifier 100 shown in figure 1 comprises a transistor 110 for amplifying said TDM(A)-signals. Said transistor may be embodied as bipolar transistor but is preferably embodied as field effect transistor FET-transistor having a source S, a gate G and a drain D. The drain source-connection of said FET-transistor is connected in series with a shunt 120 and said series connection is connected to a power supply voltage Vs. The measurement voltage dropping across said shunt 120 is input to an operational amplifier 130. Said operational amplifier 130 outputs an analog signal representing the value of said measurement voltage. Said analog signal is digitized by an analog/digital converter 140 before being input into a controlling unit 150.

Said controlling unit is preferably embodied as digital signal processor DSP. Said signal input to said signal processor 150 represents the actual operating point of the transistor 110. The controlling unit compares said actual operating point with a predefined set operating point for said transistor 110. In the case that a deviation between said set operating point and the actual operating point is detected, the controlling unit 150 outputs a control signal via a digital/analog converter 160 to the gate of said transistor 110. The control signal is typically a gate voltage. It serves for adjusting the bias of the gate of the transistor according to the detected deviation in order to re-establish the set operating point.

According to the invention the controlling unit 150 is embodied to carry out the detection of the deviation and the adjusting of the bias, i. e. the controlling of the operating point of the transistor only during null power time slots occurring within said TDM(A)-signal. Advantageously, the controlling unit is further embodied to detect the occurrence of said null power time slots nⱼ.

The controlling unit 150 is preferably embodied to carry out the controlling of the operating point during several null power time slots which do not necessarily occur consecutively within said TDM(A)-signal. More specifically, the controlling unit 150 may detect the occurrence of said null power time slots within a first one of said null power time slots, may adjust the bias within a second of said null power time slots and may optionally check the adjustment of the bias within a third one of said null power time slots. More generally, the detection of null power slots can be done by the said detection or may be already controlled/known by the controlling unit.

In the case that the null power time slots used for controlling the operating point do not occur consecutively they should occur within a time interval being much shorter than the time constant of the temperature variations causing the drift of the operating point.

The adjustment of the bias may not be done within one control loop but may be carried out iteratively during several control loops.

The method for controlling the operating point of the transistor according to the present invention is preferably carried out by a computer program for the controlling unit 150 when running on a microprocessor 152 of said controlling unit. In the case of such a software-solution the computer program may - perhaps together with other computer programs of the controlling unit - be stored on a computer-readable storage medium, e. g. a disc, a compact disc or a flash memory. When the computer program is stored on such a storage medium it may be sold to customers.

Another possibility to transmit the computer program to customers is its transmission via a communications network, in particular the Internet. In that case, no storage medium is necessary.

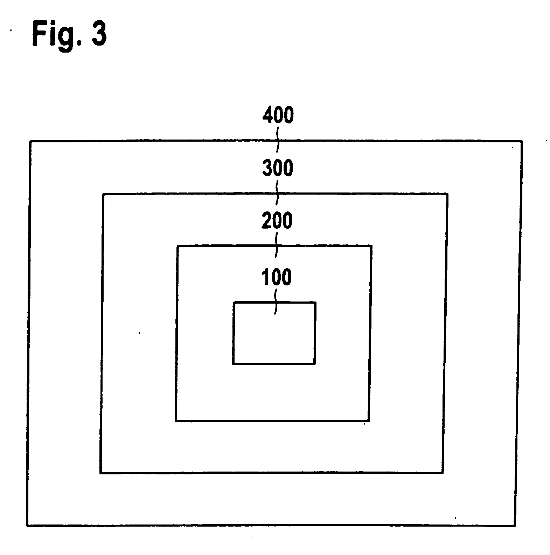

As shown in Figure 3, the power amplifier according to the invention may be comprised within a transmitter 200, in particular a radio transmitter. The power amplifier or the transmitter may be part of a transmitting station 300, in particular a radio transmitting base station. Finally, the claimed power amplifier, the transmitter or the transmitting station may be part of a telecommunications system 400, in particular a mobile radio system.

## Claims

1. Method for controlling the operating point of a transistor of a power amplifier (100) for amplifying time division multiplex (access) TDM(A)-signals, comprising the steps of:
- detecting the occurrence of null power time slots (nⱼ) within said TDM(A)-signals or using the knowledge when they occur;
- detecting a deviation between a set operating point and an actual operating point of said transistor (110); and
- adjusting the bias of the gate/base of said transistor (110) according to said detected deviation in order to re-establish said set operating point;
**characterized in that**
these steps are carried out during separate null power time slots (nⱼ) of said TDM(A)-signals.

2. Method according to claim 1, **characterized in that** the step of adjusting the bias optionally comprises the substep of:
- checking the adjustment of the bias.

3. Method according to one of the preceding claims,
**characterized in that** the null Power time slots (nⱼ) to be used arise consecutively or not within said
TDM(A)-signal.

4. Method according to one of the preceding claims,
**characterized in that** the adjustment of the bias is carried out iteratively during several control loops.

5. Method according to one of the preceding claims,
**characterized in that** the set operating point is adapted in response to the temperature in the surrounding of the transistor (110).

6. Method according to one of the preceding claims,
**characterized in that** bias means the gate/base voltage for driving the gate/base of the transistor (110).

7. Method according to one of the preceding claims,
**characterized in that** the controlling of the operating point of the transistor (110) is done only after the transistor (110) has reached a steady state with respect to its temperature after a switch-on of the Power amplifier.

8. Method according to claim 7, **characterized in that** the controlling of the operating point is started after N, e.g. N = 3, null Power time slots (nⱼ) have occurred.

9. Computer program for a controlling unit (150) of a Power amplifier (100), comprising code being adapted to carry out the method according to one of claims 1 - 8 when running an a microprocessor (152).

10. Computer program according to claim 9, **characterized in that** the code is stored an a computer-readable storage medium.

11. Power amplifier (100) for amplifying time division multiplex (access) TDM(A)-signals in a TDM(A) system, in particular in a Global System for Mobile
Communications GSM, comprising
- a transistor (110) for amplifying said TDM(A)-signals;
- a shunt (120) being connected in series to the drain-source path or collector-emitter path of said transistor (110) for providing a measurement voltage, the constant component of which representing the actual operating point of said transistor (110); and
- a controlling unit (150) for detecting the ocurrence of null power time slots (nⱼ) within said TDM(A)-signals, for detecting a deviation between a set operating point and said actual operating point of said transistor (110) and for adjusting the bias of the gate/base of said transistor (110) according to said deviation in order to re-establish said set operating point;
**characterized in that**
the controlling unit (150) is embodied to carry out the detecting and adjusting steps during separate ones of said detected null power time slots (nⱼ).

12. Power amplifier (100) according to claim 11,
**characterized in that** the controlling unit (150) is embodied as a digital signal processor.

13. Transmitter (200), in particular a radio transmitter, comprising a power amplifier (100) according to claims 11 or 12.

14. Transmitter station (300), in particular a radio transmitting base station, comprising at least one transmitter according to claim 13.

15. A telecommunications system (400), in particular a mobile radio system, comprising at least one power amplifier (100) according to one of claims 11 or 12.

## Patentansprüche

1. Verfahren zur Steuerung des Arbeitspunkts eines Transistors in einem Leistungsverstärker (100) zur Verstärkung von TDM(A)-Signalen ("Time Division Multiplex (Access)", Zeitmultiplex (Zugriff)), das die folgenden Schritte umfasst:
- Erkennen des Auftretens von Zeitfenstern ohne Leistung (nⱼ) innerhalb dieser TDM(A)-Signale oder Verwendung der Information, wann diese auftreten;
- Erkennen einer Abweichung zwischen einem eingestellten Arbeitspunkt und einem tatsächlichen Arbeitspunkt dieses Transistors (110); und
- Anpassen der Messabweichung von Gate/Basis dieses Transistors (110) gemäß dieser erkannten Abweichung zur erneuten Einrichtung dieses eingestellten Arbeitspunkts;
**dadurch gekennzeichnet, dass**
diese Schritte während separater Zeitfenster ohne Leistung (nⱼ) dieser TDM(A)-Signale ausgeführt werden.

2. Verfahren gemäß Anspruch 1, **dadurch gekennzeichnet, dass** der Schritt zum Anpassen der Messabweichung optional den folgenden Teilschritt umfasst:
- Prüfen der Anpassung der Messabweichung.

3. Verfahren gemäß einem der vorigen Ansprüche, **dadurch gekennzeichnet, dass** die zu verwendenden Zeitfenster ohne Leistung (nⱼ) innerhalb dieses TDM(A)-Signals aufeinander folgen oder nicht aufeinander folgen.

4. Verfahren gemäß einem der vorigen Ansprüche, **dadurch gekennzeichnet, dass** die Anpassung der Messabweichung iterativ während verschiedener Regelkreise durchgeführt wird.

5. Verfahren gemäß einem der vorigen Ansprüche, **dadurch gekennzeichnet, dass** der eingestellte Arbeitspunkt angepasst wird als Reaktion auf die Temperatur in der Umgebung des Transistors (110).

6. Verfahren gemäß einem der vorigen Ansprüche, **dadurch gekennzeichnet, dass** der Begriff Messabweichung die Gate/Basis-Spannung zur Steuerung von Gate/Basis des Transistors (110) kennzeichnet.

7. Verfahren gemäß einem der vorigen Ansprüche, **dadurch gekennzeichnet, dass** die Steuerung des Arbeitspunkts des Transistors (110) erst erfolgt, nachdem der Transistor (110) nach dem Einschalten des Leistungsverstärkers einen stabilen Status hinsichtlich seiner Temperatur erreicht hat.

8. Verfahren gemäß Anspruch 7, **dadurch gekennzeichnet, dass** die Steuerung des Arbeitspunkts gestartet wird, nachdem N Zeitfenster ohne Leistung (nⱼ) aufgetreten sind, wobei z. B. N=3.

9. Computerprogramm für eine Steuereinheit (150) eines Leistungsverstärkers (100), das einen Code umfasst, mit dem bei Ausführung auf einem Mikroprozessor (152) das Verfahren gemäß einem der Ansprüche 1 - 8 durchgeführt werden kann.

10. Computerprogramm gemäß Anspruch 9, **dadurch gekennzeichnet, dass** der Code auf einem computerlesbaren Speichermedium gespeichert ist.

11. Leistungsverstärker zur Verstärkung von TDM(A)-Signalen ("Time Division Multiplex (Access)", Zeitmultiplex (zugriff)) in einem TDM(A)-System, insbesondere in einem globalen System für die Mobilkommunikation (GSM), wobei der Leistungsverstärker Folgendes umfasst:
- Transistor (110) zur Verstärkung dieser TDM(A)-Signale;
- Nebenanschluss, in Reihe angeschlossen an den Drain-Source-Pfad oder den Kollektor-/Emitterpfad dieses Transistors (110) zur Bereitstellung einer Messungsspannung, deren konstante Komponente den tatsächlichen Arbeitspunkt dieses Transistors (110) darstellt; und
- Steuereinheit (150) zum Erkennen des Auftretens von Zeitfenstern ohne Leistung (nⱼ) innerhalb dieser TDM(A)-Signale, zum Erkennen einer Abweichung zwischen einem eingestellten Arbeitspunkt und diesem tatsächlichen Arbeitspunkt dieses Transistors (110) und zum Anpassen der Messabweichung von Gate/Basis dieses Transistors (110) gemäß dieser Abweichung zur erneuten Einrichtung dieses eingestellten Arbeitspunkts;
**dadurch gekennzeichnet, dass**
die Steuereinheit (150) vorzugsweise so ausgeführt ist, dass sie die Schritte zum Erkennen und Anpassen in separaten dieser erkannten Zeitfenster ohne Leistung (nⱼ) ausführt.

12. Leistungsverstärker (100) gemäß Anspruch 11, **dadurch gekennzeichnet, dass** die Steuereinheit (150) als ein digitaler Signalprozessor ausgeführt ist.

13. Sender (200), insbesondere ein Funksender, der einen Leistungsverstärker (100) gemäß Anspruch 11 oder 12 umfasst.

14. Senderstation (300), insbesondere eine Funksender-Basistation, die mindestens einen Sender gemäß Anspruch 13 umfasst.

15. Telekommunikationssystem (400), insbesondere ein Mobilfunksystem, das mindestens einen Leistungsverstärker (100) gemäß einem der Ansprüche 11 oder 12 umfasst.

## Revendications

1. Procédé destiné au contrôle du point de fonctionnement d'un transistor d'un amplificateur de puissance (100) destiné à l'amplification des signaux de multiplexage par répartition dans le temps (TDMA), comprenant les étapes de :
- détection de l'occurrence des créneaux temporels de puissance nulle (nⱼ) au sein desdits signaux TDMA ou de l'utilisation de connaissances quand ils se présentent ;
- détection d'une déviation entre le point de fonctionnement de consigne et un point de fonctionnement réel ou ledit transistor (110) ; et
- réglage de la polarisation de la grille/base dudit transistor (110) selon ladite déviation détectée afin de rétablir ledit point de fonctionnement de consigne ;
**caractérisé en ce que**
ces étapes sont réalisées pendant les créneaux temporels de puissance nulle séparés (nⱼ) desdits signaux TDMA.

2. Procédé selon la revendication 1, **caractérisé en ce que** l'étape de réglage de la polarisation comprend facultativement la sous-étape de :
- contrôle du réglage de la polarisation.

3. Procédé selon l'une quelconque des revendications précédentes, **caractérisé en ce que** les créneaux temporels de puissance nulle (nj) à utiliser surviennent consécutivement ou pas au sein desdits signaux TDMA.

4. Procédé selon l'une quelconque des revendications précédentes, **caractérisé en ce que** le réglage de la polarisation est réalisé de manière itérative pendant plusieurs boucles de contrôle.

5. Procédé selon l'une quelconque des revendications précédentes, **caractérisé en ce que** le point de fonctionnement de consigne est adapté en réaction à la température dans l'environnement du transistor (110).

6. Procédé selon l'une quelconque des revendications précédentes, **caractérisé en ce que** polariser signifie la tension de grille/base destinée à attaquer la grille/base du transistor (110).

7. Procédé selon l'une quelconque des revendications précédentes, **caractérisé en ce que** le contrôle du point de fonctionnement du transistor (110) est effectué seulement après que le transistor (110) a atteint un état stable par rapport à sa température après une commutation en fonction de l'amplificateur de puissance.

8. Procédé selon la revendication 7, **caractérisé en ce que** le contrôle du point de fonctionnement est commencé après que N, par exemple N = 3, créneaux temporels de puissance nulle (nⱼ) se sont présentés.

9. Programme informatique destiné à une unité de contrôle (150) d'un amplificateur de puissance (100), comprenant un code adapté pour réaliser le procédé selon l'une quelconque des revendications 1 à 8 quand il est exécuté sur un microprocesseur (152).

10. Programme informatique selon la revendication 9, **caractérisé en ce que** le code est mémorisé sur un support de stockage pouvant être lu par ordinateur.

11. Amplificateur de puissance (100) destiné à l'amplification des signaux de multiplexage par répartition dans le temps (TDMA) dans un système TDMA, en particulier, dans un système mondial de télécommunications mobiles GSM, comprenant
- un transistor (110) destiné à l'amplification desdits signaux TDMA ;
- un shunt (120) monté en série sur le chemin drain-source ou sur le chemin collecteur-émetteur dudit transistor (110) destiné à la fourniture d'une tension de mesure, dont le composant constant représente le point de fonctionnement réel dudit transistor (110) ; et
- une unité de contrôle (150) destinée à la détection de l'occurrence des créneaux temporels de puissance nulle (nⱼ) au sein desdits signaux TDMA, destinée à la détection d'une déviation entre un point de fonctionnement de consigne et ledit point de fonctionnement réel dudit transistor (110) et destinée au réglage de la polarisation de la grille/base dudit transistor (110) selon ladite déviation afin de rétablir ledit point de fonctionnement de consigne ;
**caractérisé en ce que**
l'unité de contrôle (150) est incorporée pour réaliser les étapes de détection et de réglage pendant des créneaux temporels de puissance nulle séparés parmi lesdits créneaux temporels de puissance nulle détectés (nⱼ).

12. Amplificateur de puissance (100) selon la revendication 11, **caractérisé en ce que** l'unité de contrôle (150) est incorporée en tant que processeur de signal numérique.

13. Emetteur (200), en particulier, un émetteur radio, comprenant un amplificateur de puissance (100) selon les revendications 11 ou 12.

14. Station émettrice (300), en particulier, une station de base de transmission radioélectrique, comprenant au moins un émetteur selon la revendication 13.

15. Système de télécommunications (400), en particulier, un système radio mobile, comprenant au moins un amplificateur de puissance (100) selon l'une quelconque des revendications 11 ou 12.
